# EUROPEAN PATENT APPLICATION

(11) **EP 0 712 185 A1**
(43) Date of publication of application: **15.05.1996**
(21) Application number: 95308038.9
(22) Date of filing: 09.11.1995
(51) Int. Cl.: H01S 3/19, H01S 3/25, H01L 21/22

(54) **Index-guided visible laser formed by selectively randomizing the ordered phase of ALGaInP**

(30) Priority: 10.11.1994 US 336968
(71) Applicant: XEROX CORPORATION, Rochester New York 14644 (US)
(72) Inventor: Bour, David P., Cupertino, California 95014 (US)
(74) Representative: Goode, Ian Roy

(57) **Abstract**

An index-guided laser structure comprising, in order, a substrate (12), a first cladding layer (14) of a first polarity type, a first confining layer (16), an active layer (18), a second confining layer (20) and a second cladding layer (22) of a second polarity type, the layers being of an alloy of AlGalnP. The laser is created by controlled randomization of the ordered alloy of AlGalnP. Such lasers have an ordered-alloy laser stripe, clad by regions (27) where the alloy is selectively disordered. The randomization is performed to a sufficient depth and magnitude so as to create an optical cavity that functions as a lateral optical waveguide due to variations in the optical refractive index properties of the disordered region.

## Description

This invention relates to index-guided, visible light emitting semiconductor lasers.

Index-guided semiconductor lasers have proven to be useful light sources. Index guiding refers to the use of variations in the optical index of refraction between material layers to provide for optical confinement, also referred to as waveguiding. Index-guided semiconductor lasers have an active region fabricated from a suitable material system, carrier confinement, optical (or radiation) confinement, and optical feedback. For example, a typical index-guided semiconductor laser may have a heterostructure formed in an AlGalnP material, a lateral waveguide which provides for optical and carrier confinement, and an optical Fabry-Perot cavity formed from cleaved facets. The AlGalnP material system is particularly useful for fabricating visible light emitting semiconductor lasers.

This document makes use of the subscripted notation, A_{M}L_{N}, where the nonsubscript terms (A and L) designate a material (be it an element or a compound) while the subscripted terms (M and N) designate the atomic concentration of their associated material. Parentheses are used to identify compounds which act together. For example, the notation (AlₓGa₁₋ₓ)_{0.5}In_{0.5}P implies that half of the material is phosphorous, one quarter is comprised of indium, and the remaining quarter is a compound of aluminum and gallium in which the composition takes a range (0 ≤ x ≤ 1) from all aluminum (x is equal to 1) to all gallium (x is equal to 0). It is to be understood that the subscripted terms are only approximations. For example, in a material designated as (AlₓGa₁₋ₓ)_{0.5}In_{0.5}P, the percentages x and 0.5 may vary slightly (such as by ± 0.05). However, for convenience the general alloy (AlₓGa₁₋ₓ)_{y}In_{1-y}P will at times be denoted simply as AlGalnP.

Most index guided visible laser diodes, at least in the AlGalnP material system, achieve index guiding by the use of ridged waveguides. Such waveguides are either simple ridge waveguides, or selectively buried ridge waveguides. Simple ridge waveguides offer relatively weak guiding (index step Δn ∼ 0.01), and thus are susceptible to carrier-induced antiguiding, and instabilities due to gain-spatial hole burning and thermal waveguiding. This leads to oscillations of the higher-order modes of the waveguide. While selectively buried ridge (SBR) waveguides are similarly weakly guided, layers regrown over the ridges (usually GaAs) discriminate against higher-order optical modes, although at the expense of higher optical losses in the fundamental mode. Such losses reduce the overall efficiency of the lasers and increase the current thresholds. Consequently, there is a need for better index-guided lasers.

Other ways of achieving index guiding, such as impurity-induced layer disordering (IILD) and vacancy-enhanced layer disordering, are also known. Layer disordering refers to the intermixing of the layers which comprise the semiconductor laser heterostructure. For instance, a quantum well active layer may be intermixed into the surrounding, higher-bandgap confinement region. Consequently, in the vicinity of the active region the bandgap energy is increased and the refractive index is decreased. Therefore, selective IILD is the basis for creating a strong lateral waveguide and a current-confining structure.

However, at least in the (AlₓGa₁₋ₓ)_{0.5}In_{0.5}P (0 ≤ x ≤ 1) material system, these processes can introduce deviations from the lattice-matched compositions. Large mismatches result in strains, which lead to dislocations, which can degrade laser performance and reduce the laser's lifetime. In the case of IILD in the AlGalnP material system very large strains appear when a GaAs capping layer intermixes with the underlying phosphide material, leading to a large density of undesirable near-surface dislocations. For this and other reasons, IILD is not well developed for AlGalnP heterostructures.

(AlₓGa₁₋ₓ)_{0.5}In_{0.5}P not only lattice matches with GaAs substrates, it can be grown using organometallic vapor phase epitaxy (OMVPE). Interestingly, OMVPE-grown AlGalnP exhibits two distinct, and relatively easily created, phases: an ordered phase which consists of a monolayer InP/AlₓGa₁₋ₓP superlattice formed by spontaneous atomic organization during growth and which is characterized by a lower bandgap, and thus a higher refractive index; and a random-alloy phase that has no ordering on the group III sublattice and which has a higher bandgap and a lower refractive index. For comparison, the bandgap difference between the ordered and the random phases of Ga_{0.5}In_{0.5}P is between 70-100 meV.

Since prior art index guided lasers suffer from numerous deficiencies, other types of index guided semiconductor lasers would be useful. Of particular interest would be techniques which take advantage of the distinct phases of OMVPE-grown AlGalnP.

It is an object of the present invention to provide improved index guided lasers which take advantage of such techniques.

According to the present invention, there is provided a laser comprising: a substrate: a first cladding layer of a first polarity type adjacent said substrate; a first confining layer adjacent said first cladding layer; an active region adjacent said first confining layer; a second confining layer adjacent said active region; and a second cladding layer of a second polarity type adjacent said second confining layer; wherein said first and second confining layers and said first and second cladding layers comprise semiconductor materials which partially have an ordered phase and which partially have a random phase, wherein said ordered and random phases have different indexes of refraction, and wherein said different indexes of refraction of said ordered and random phases provide optical confinement for said laser.

The present invention thus provides for index-guided laser structures which achieve indexing using controlled randomization of the ordered alloy, which is preferably an alloy of AlGalnP. Such lasers have an ordered-alloy laser stripe which is clad by regions where the alloy is selectively disordered. The randomization is performed to a sufficient depth so as to create an optical cavity that functions as a lateral optical waveguide due to variations in the optical refractive index properties of the disordered region.

While randomization of the ordered alloy can be achieved in several ways, controlled zinc diffusion is of particular interest. Lasers according to the present invention which are randomized using zinc diffusion can be fabricated in a near-planar configuration, can have low thresholds, and can be fabricated in arrays of closely spaced lasers.

A laser according to the invention will now be described, by way of example, with reference to the accompanying drawings, in which :-
Figure 1 schematically illustrates a semiconductor laser according to the principles of the present invention; and
Figure 2 schematically illustrates an array of semiconductor lasers according to the principles of the present invention.

The subsequent text includes various directional terms (such as over, above, and on top) which are related to the Figures. Those terms are meant to aid the understanding of the present invention, not to limit it.

Impurity induced disordering (IID) is known in the prior art. Typically, impurity induced disordering involves the intermixing of atoms on a group III sublattice. When the group III sublattice of AlGalnP is ordered, the indium atoms occupy {111} planes which are adjacent to {111} planes containing aluminum and gallium atoms, thereby creating a monolayer AIGaP / InP superlattice on the {111} plane(s). However, when AlGalnP is not ordered the Al, Ga, and In atoms are distributed randomly throughout the crystal. Interestingly, ordered AlGalnP can be randomized in several ways, including the diffusion of zinc into the ordered phase.

According to the principles of the present invention, impurity induced disordering is used to produce an optical waveguide for an OMVPE-grown AlGalnP laser structure. Rather than disordering all of the heterostructure layers, the present invention disorders only the monolayer {111} superlattice of the OMVPE-grown AlGalnP. Such disordering selectively produces a randomized alloy from the ordered alloy. Since the random alloy of (AlₓGa₁₋ₓ)_{0.5}In_{0.5}P has a higher bandgap, and thus a lower refractive index, than the ordered alloy, the random alloy provides both carrier confinement and optical confinement, i.e., waveguiding, relative to the ordered phase. By locating the optical waveguide properly relative to a laser stripe fabricated from the ordered alloy, index-guided lasers may be constructed. Although the resultant lateral index step across the random alloy is not as great as for a completely intermixed heterostructure (such as would result from IILD), the index step is greater than that achieved in a ridge or a selectively-buried ridge waveguide laser.

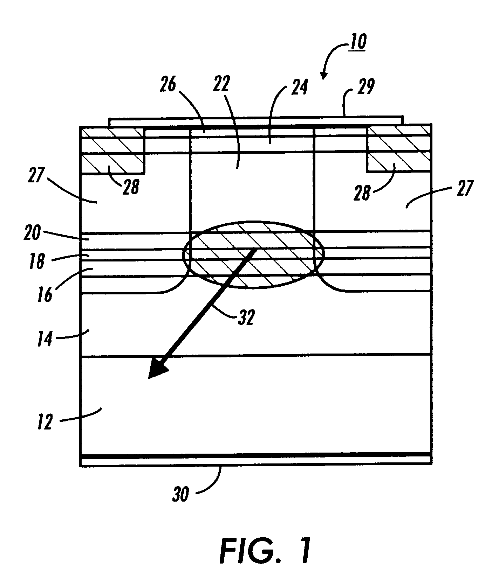

The principles of the present invention will become clearer after a review of Figure 1 and the following text. Refer now to Figure 1 for an illustration of a prototypical visible light emitting laser 10 according to the principles of the present invention. The laser 10 is comprised of a plurality of ordered-phase AlGalnP layers grown on a (100) GaAs substrate 12. As illustrated, the (AlₓGa₁₋ₓ)_{y}In_{1-y}P layers include an N-type cladding layer 14 (y = 0.5 ± 0.05, 0.4<x<1.0) on the substrate, a lower confining layer 16 (y= 0.5 ± 0.05, 0.2<x<0.7) over the cladding layer 14, and an active region 18 (0.2<y<0.7, 0<x<0.4) over the confining layer 16. The active region could be a single quantum well, multiple quantum wells, or a double heterostructure.

Over the active region 18 is an upper confining layer 20 (y = 0.5 ± 0.05, 0.2 < x < 0.7), followed by a P-type cladding layer 22 (y = 0.5 ± 0.05, 0.4 < x <1.0). The various AlGalnP layers 14 through 22 are initially grown using organometallic vapor phase epitaxy (OMVPE) under conditions such that the ordered phase of AlGalnP, having a low-bandgap, high refractive index, occurs. To facilitate the formation of ohmic metal-semiconductor contacts, a GalnP barrier reduction layer 24 and a GaAs p⁺-cap layer 26 are placed on top of the p-cladding layer.

Fabrication of the laser 10 is relatively straightforward. With the various AlGalnP layers 14 through 22 in place, a masking layer (not shown) is placed over the GaAs cap layer 22 above where the laser stripe is to be located. This masking layer protects the laser stripe area from subsequent processing steps which selectively disorder, or randomize, the natural {111} superlattice of the ordered alloy. With the mask in place, parts 27 of the AlGalnP layers 14 through 22 are randomized. This is accomplished by diffusing zinc through the various layers 16-22, and into the layer 14. Zinc diffusion can be performed in several ways, for example, using vapor or solid ZnO sources. Other ways of selectively randomizing the ordered phases of the various layers 14-22 might include vacancy-enhanced intermixing, IILD with silicon or germanium, and ion implantation and annealing.

With the masking layer still in place, blocking regions 28 are created on the AlGalnP P-type cladding layer 22. These blocking regions block current injection into the randomized layers and the shunting of current around the sides of the laser stripe so as to guide current flow into the laser stripe. The blocking regions are beneficially formed using shallow proton implantation into the AlGalnP cladding layer 22. Alternatively, a deposited dielectric layer, shallow diffusion of an n-type impurity, or an etch into the p-cladding layer could also be used to accomplish current-blocking. After formation of the blocking regions 28 the masking layer is removed. An upper metallic contact 29 is then placed over the cap layer 26, and a lower metallic contact 30 is placed under the substrate 12. When current flows through the metallic contacts, visible laser light 32 is emitted from the active regions.

Zinc diffusion has also been used to accomplish IILD for AlGaAs lasers. However, because zinc is highly active (electrically) in AlGaAs, the resultant hole concentrations are very high, thereby leading to high free-carrier losses. Despite this problem with zinc-diffusion for AlGaAs lasers, it may be less problematic for AlGalnP materials. If cladding layers without Ga are used, i.e., AllnP cladding layers, zinc diffusion does not necessarily lead to high hole concentrations in the P-type cladding layer 22. This implies that the P-cladding layer 22 would not have high free-carrier optical losses. Although the zinc is more electrically active in the lower-aluminum-content confining and active region, it is still less active than in AlGaAs. For instance, in the (AlₓGa₁₋ₓ)_{0.5}In_{0.5}P (0.5<x<0.7) confining region of a quantum well laser, the highest p-doping levels achieved with zinc (at the solubility limit) are in the low-mid 10¹⁸ cm⁻³. Thus, although zinc diffusions lead to high free-carrier losses in AlGaAs lasers, these losses could be lower for a similar process performed with AlGalnP lasers, as a result of the poor electrical activity of zinc in AlGalnP.

As previously noted the bandgap difference between the ordered and random phases of Ga_{0.5}In_{0.5}P is 70-100 meV. Thus, the laser stripe of the laser 10 offers lateral current confinement. Furthermore, since the bandgap is increased for the random alloy, its refractive index is also reduced. A bandgap difference of 70<ΔE_{g}< 100 meV corresponds to an (AlₓIn₁₋ₓ)_{0.5}In_{0.5}P composition difference (Δx) of 0.12<Δx<0.17, which, in turn is equivalent to a refractive index difference (Δn) of 0.05<Δn<0.07 at 680 nm (the lasing wavelength of a GaInP/AlGaInP DH laser with an ordered active region). Since the refractive indices of all the random alloy compositions are increased by this amount as compared to the ordered alloys, the overall modal effective index is also similarly increased by approximately this amount. Therefore, the lateral index step in the random/ordered/random stripe laser structure is estimated to be approximately 50 - 70 x 10⁻³. This is less than that which can be achieved in a buried heterostructure laser or a fully intermixed heterostructure by llLD (in which cases Δn may be as high as several hundred x 10⁻³). However, this is a much greater index step than in a ridged waveguide or a SBR ridged waveguide laser. Therefore, lasers according to the principles of the present invention offer better beam quality (less astigmatism, and potentially more circular beams), and single-mode stability without optical loss as great as those in the SBR ridged waveguide lasers.

Lasers according to the principles of the present invention have several advantages over ridged waveguide lasers. They are more strongly index-guided. They reduce the difficulty of making narrow striped lasers and are more conducive to the fabrication of arrays of closely-spaced, individually-addressable lasers.

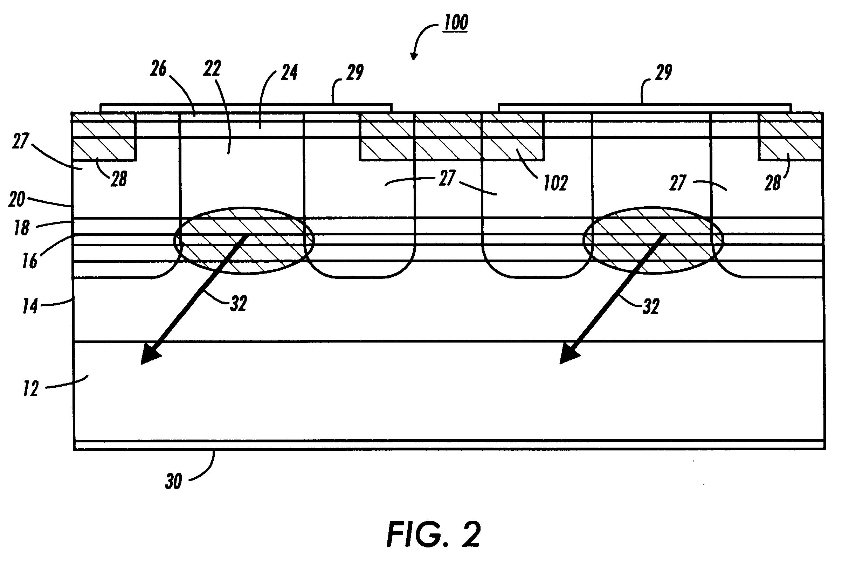

The process of selective randomization of the ordered AlGalnP alloy can also be used to fabricate arrays of index-guided lasers, as shown in Figure 2. While Figure 2 only shows a planar array 100 of two closely spaced index-guided AlGalnP lasers formed by selective disordering, in practice many such lasers can be fabricated at the same time. Note that the same semiconductor layers exist in both the single laser 10 of Figure 1 and the laser array 100 of Figure 2.

The array 100 could be fabricated, for example, in a manner similar to the fabrication of the single laser diode 10. First, a masking layer (not shown, but possibly a Si₃N₄, film), is deposited and patterned. Subsequently, zinc is diffused into openings in the mask, to create regions of random phase AlGalnP 27. As in the case of the single laser diode 10, the randomized regions 27 serve as the cladding of a lateral waveguide. However, in the laser array 100, to better electrically isolate adjacent elements of the array, a shallow proton implant is performed. Since this process creates an insulating surface barrier 102 between the devices, electrical isolation is improved, and the alignment tolerance for the p-contact metal 29 is relaxed. With such a planar process, the elements of the array 100 could be spaced very close together, with as little as 5 - 10 microns separation. Furthermore, electrical and optical crosstalk would also be minimized, because of the strong lateral carrier and optical confinement, along with the electrical isolation between devices.

Compared to arrays of selectively-buried ridge waveguide lasers, arrays such as array 100 can perform better, and as a consequence of the planar processing, the array elements can be spaced closer together. A problem exists in the array 100 in that the electrical isolation between active regions may not be very strong. However, other types of arrays which use the principles of the present invention are possible. For example, an array similar to laser array 100, but with a proton implantation which extends through the upper cladding layer would have improved electrical isolation. However, deep proton implantations would potentially introduce damage in the active regions, possibly leading to rapid device failure. Another type of array would have a deep, etched groove between the active regions. This would maximize isolation, but at the expense of creating a non-planar architecture.

## Claims

1. A laser comprising:
a substrate (12) :
a first cladding layer (14) of a first polarity type adjacent said substrate;
a first confining layer (16) adjacent said first cladding layer;
an active region (18) adjacent said first confining layer;
a second confining layer (20) adjacent said active region; and
a second cladding layer (22) of a second polarity type adjacent said second confining layer;
wherein said first and second confining layers (16,20) and said first and second cladding layers (14,22) comprise semiconductor materials which partially have an ordered phase and which partially have a random phase (27), wherein said ordered and random phases have different indexes of refraction, and wherein said different indexes of refraction of said ordered and random phases provide optical confinement for said laser.

2. The laser according to claim 1, wherein said first and second confining layers (16,20) and said first and second cladding layers (14,22) comprise (AlₓGa₁₋ₓ)_{1-y}In_{y}P, wherein (0 ≤ x ≤ 1) and wherein (y = 0.5 ± 0.05).

3. The laser according to claim 1 or claim 2, wherein said substrate (12) is GaAs.

4. The laser according to any one of claims 1 to 3, wherein said active region (18) includes a single quantum well.

5. The laser according to any one of claims 1 to 3, wherein said active region (18) includes multiple quantum wells.

6. The laser according to any one of claims 1 to 3, wherein said active region (18) includes a double heterostructure.

7. An array of laser devices comprising a plurality of lasers according to any one of claims 1 to 6, spaced apart from one another on the same substrate, and substantially electrically isolated from one another.

8. An array of laser devices comprising:
a substrate:
a first cladding layer of a first polarity type adjacent said substrate;
a first confining layer adjacent said first cladding layer;
a first active region adjacent said first confining layer;
a second active region adjacent said first confining layer and said first active region;
a second confining layer adjacent said first and second active regions; and
a second cladding layer of a second polarity type adjacent said second confining layer;
wherein said first and second confining layers and said first and second cladding layers include semiconductor materials which partially have an ordered phase and which partially have a random phase, wherein said ordered and random phases have different indexes of refraction, and wherein said different indexes of refraction of said ordered and random phases provide optical confinement for said first and second active regions.
